Europäisches Patentamt

European Patent Office

Office européen des brevets

(19)

(11) Publication number: **0 086 532**
**B1**

# EUROPEAN PATENT SPECIFICATION

(45) Date of publication of patent specification: **07.05.86**

(51) Int. Cl.⁴: **H 01 G 1/035, H 05 K 3/34**

(21) Application number: **83200190.3**

(22) Date of filing: **07.02.83**

(54) **Electric component with upset connection wires.**

(30) Priority: **12.02.82 NL 8200533**

(43) Date of publication of application:
**24.08.83 Bulletin 83/34**

(45) Publication of the grant of the patent:
**07.05.86 Bulletin 86/19**

(84) Designated Contracting States:
**DE FR GB IT**

(56) References cited:
**DE-A-2 812 767**
**DE-A-2 828 231**
**GB-A-1 150 206**
**GB-A-1 186 247**
**GB-A-2 004 695**
**NL-A- 296 140**
**US-A-3 977 075**

(73) Proprietor: **N.V. Philips' Gloeilampenfabrieken**
**Groenewoudseweg 1**
**NL-5621 BA Eindhoven (NL)**

(72) Inventor: **Marneffe, Antonius Christianus**
**c/o INT.OCTROOIBUREAU B.V. Prof.Holstlaan 6**
**NL-5656 AA Eindhoven (NL)**
Inventor: **Persoon, Frederik Gerardus Adrianus**
**c/o INT.OCTROOIBUREAU B.V. Prof.Holstlaan 6**
**NL-5656 AA Eindhoven (NL)**
Inventor: **Kluvers, Willem Dirk Jan**
**c/o INT.OCTROOIBUREAU B.V. Prof.Holstlaan 6**
**NL-5656 AA Eindhoven (NL)**

(74) Representative: **Cuppens, Hubertus Martinus**
**Maria et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to an electric component having at least one connection made of metal wire to be mounted in a through-hole of a support with a printed circuit, this connection being provided with a shoulder adapted to bear on the support in a region located around the hole in the support and thus determining the insertion depth of the connection.

In an electric component known from DE—A—2,812,767, and corresponding to an electric component comprising the features in the pre-characterising part of claim 1 the shoulder has on the side facing the support two diametrically oppositely arranged ramplike flattened portions engaging the support. A profile in the form of a dome is present between the two ramplike flattened portions. Between this profile and the wall of the hole in the support, the space is present which on both sides is in open communication with the surroundings and which during soldering acts as a passage for the gases produced during this soldering operation.

The known electric component has the disadvantage that the die used for forming (upsetting) the shoulder is comparatively expensive due to the two ramplike flattened portions. These flattened portions require a number of additional operations in the manufacture of the die. A further disadvantage is that the ramplike flattened portions lead to a comparatively large amount of wear of the die due to thrust of the material to be deformed and the associated high surface pressure. Furthermore, the ramplike flattened portions result in that the height of the shoulder is comparatively large so that a larger quantity of material is required for the formation of the shoulder.

The invention has for its object to provide an electric component with connection wires which are provided with a shoulder and which can be manufactured by means of a comparatively simple die, which moreover is susceptible to a comparatively small amount of wear and which component is particularly suitable for high-frequency applications.

An electric component according to the invention is therefore characterized in that the shoulder has the form of a disk having two oppositely arranged flattened portions which are parallel to each other and to the central axis of the connection, the distance between the two flattened portions being smaller than the dimension of the shoulder in a direction at right angles thereto, while the connection has a part joining the shoulder and having a substantially oval cross-section with a smallest surface area at the end remote from the shoulder and a largest surface at the end facing the shoulder, the surface of the cross-section of this part decreasing substantially linearly from the shoulder and the plane through the major axis of the oval cross-section of this part coinciding with the plane located equidistantly between the two flattened portions of the shoulder.

The operation of upsetting a shoulder with flattened portions as described above requires a simple die, the die halves of which are provided with straight-through semicylindrical cavities, while the flattened portions need be provided only after the disk-shaped shoulder has been formed by flattening the latter between two parallel flat walls.

The tapering (funnel-shaped) form of the profile renders it possible to hold the connection during the formation of the shoulder on the side facing the component over a comparatively small height in the upsetting tool. Due to the funnel-shaped form, an excessive extrusion of the metal of the connection is avoided. The comparatively small height for holding the connection in the upsetting tool results in that the length of the connection between the component and the support can be a minimum, which in high-frequency applications of the electric component leads to low induction losses and low losses due to the so-called "skin effect" occurring in the connections.

The invention will be described more fully with reference to the drawing, in which:

Figure 1 is a front elevation to scale of a part of an electric component according to the invention, which is secured to a support with a printed circuit by soldering,

Figure 2 is a side elevation of an electric component as shown in Figure 1,

Figure 3 is a sectional view taken on the line III—III in Figure 1.

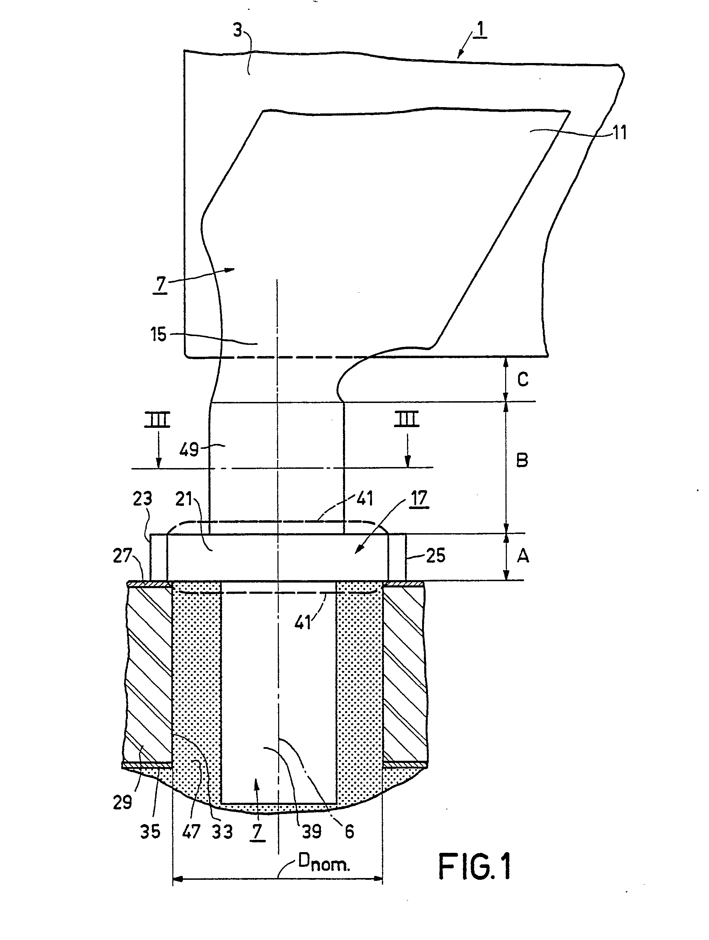

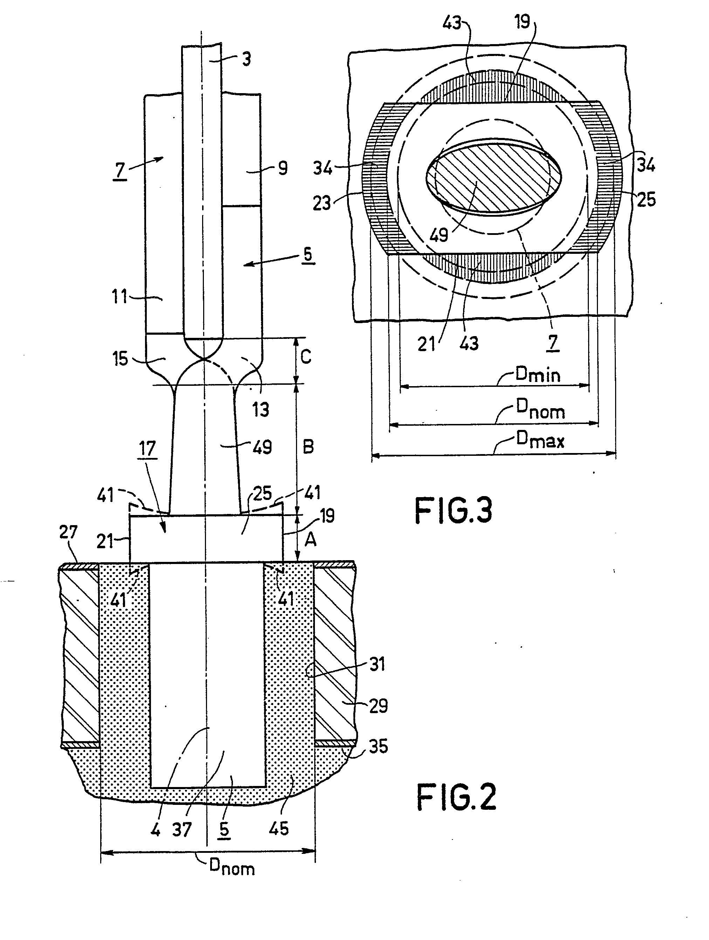

The electric component 1 shown in Figures 1 and 2 according to the invention is an assembly of a ceramic plate capacitor 3 to which connection wires 5 and 7 are secured by soldering in a manner known *per se* (for example, from the United States Patent Specification 3,691,436). Preferably, connection wires of tin-plated copper are used. The plate capacitor 3 is arranged between crossing flattened portions 9 and 11 of the connection wires 5 and 7, respectively (not shown in the drawing for the sake of brevity). The central plane (plane of symmetry) of the capacitor 3 in Figure 1 is parallel to the plane of the drawing and coincides (see Figure 2) with the plane passing through the central axes 4 and 6 of the connection wires 5 and 7. In Figure 2, the latter plane is at right angles to the plane of the drawing. For this purpose, the connection wires 5 and 7 are provided in the proximity of the lower side of the capacitor 3 with knees 13 and 15. The flattening planes of the flattened portions 9 and 11 are at right angles to the plane of the drawing in Figure 2. For the sake of clarity, the usual electrically insulating lacquer layer enveloping the capacitor 3 and a part of the connection wires 5 and 7 is not shown in the drawing.

In regions, which are designated in Figures 1 and 2 by the distances A, B and C, the connection wires 5 and 7 have characteristic deformations, which will be described more fully below. Since the connection wires 5 and 7 are identical below the lower side of the capacitor 3, use is made of the same reference numerals for the relevant parts of the two connection wires. This is especially the case in Figure 2 because there only the upper part of the connection wire 7 and the whole connection wire 5 are visible.

In the region A, the connection wires are provided with a shoulder 17. The shoulder 17 is formed by cold upsetting of the connection wire. The shoulder 17 is substantially disk-shaped. The shoulder 17 has two diametrically oppositely arranged flattened portions 19 and 21 (see Figure 3), the plane of which is parallel to the plane of the drawing in Figure 1. The expression "disk-shaped" is therefore to be interpreted in a wide sense so as to mean "formed from a disk" and is on the other hand not to be considered to include shoulders which have a circular shape. Also the expression "diametrical" is not to be interpreted in a purely mathematical sense. After the flattened portions 19 and 21 have been formed, the non-flattened portions 23 and 25 no longer have a fully circular shape either. With the lower side of the two shoulders 17 the component 1 is supported on the printed circuit 27 of a support 29 in a region located near circular holes 31 and 33 for the connection wires 5 and 7, respectively. The central axes of the holes 31 and 33 coincide with the axes 4 and 6, respectively. This region is designated for the hole 33 in Figure 3 by a horizontal cross-hatched line 34. The support 29 is a support with a double-sided printed circuit, *i.e.* the aforementioned printed circuit 27 on the upper side and a further printed circuit 35 on the lower side of the support 29. The use of a support with a single-sided printed circuit is also possible. The shoulders 17 determine the insertion depth of the connection wires 5 and 7 into the holes 31 and 33. The ends 37 and 39 of the connection wires 5 and 7 inserted into the holes 31 and 33 have a circular cross-section and are not deformed. Due to the flattening of the shoulders 17, the material is slightly thrust, which in Figures 1 and 3 is indicated by a dotted line 41. This thrust of material has the effect that in practice a smaller insertion depth of the connection wires 5 and 7 is attained, otherwise without any detrimental effect. Preferably, the thrust material is left in place, but it may also be removed by grinding. The diameters of the holes in supports usual in practice lie between $D_{min}$ and $D_{max}$ with a nominal value $D_{nom}$. In the situation shown in Figure 3, $D_{nom}$ is the so-called determinative diameter, that is to say the diameter which determines the engagement surface between the shoulder and the support. The shoulders 17 are proportioned so that their longest dimension largely exceeds the value $D_{max}$. Due to the flattened portions 19 and 21, on either side of the shoulder 17 the space indicated by a vertical cross-hatched line 43 is left free between the connection wires 5 and 7 and the walls of the holes 31 and 33, respectively. The spaces 43 serve as passages for the gases produced during soldering and therefore contribute essentially to the qualities of the soldering connections 45 and 47. The said gases can espace in this manner so that gas occlusions in the soldering connections 45 and 47 are avoided.

In the region B, the connection wires are provided with a part 49 (profile), further on called neck with an oval cross-section (viewed in a plane at right angles to the axes 4 and 6, see Figure 3). The surface area of the cross-section of the neck 49 decreases linearly from the shoulder 17 towards the component 1 (see Figure 2). As appears from Figure 1, the neck 49 has a constant width, viewed in the plane of the drawing of Figure 1. The neck 49 is formed just before the shoulder 17 is upset. Preferably, a bipartite die is used by means of which in a first die part the neck 49 and subsequently in a second die part the shoulder 17 are formed. The flattened portions 19 and 21 are formed in a separate operation by clamping the shoulder 17 between two parallel flat walls in a separate tool. The tapering shape (funnel-shaped form) of the neck 49 has the advantage that the gripping height (= distance B) on the upper side of the shoulder 17 still to be formed can be kept as small as possible during the operation of upsetting the shoulder 17. Due to its form, the neck 49 counteracts extrusion of the material. The extrusion can be limited to approximately the distance designated by C. If the neck 49 should have a cylindrical form, the required gripping height is larger in order to avoid an unacceptable extrusion. The comparatively small gripping height B due to the tapering neck 49 has the advantage that the overall distance B + C between the component 1 and the shoulder 17 can be limited to a minimum. This is of importance for components which have to operate at the high frequencies at which the so-called "skin effect" occurs. At such frequencies, induction losses also occur. Both the losses due to the "skin effect" and those due to induction are strongly dependent upon the overall distance B + C between the component and the shoulder, that is to say in a sense such that the losses increase with an increase in distance B + C. In order to obtain a representation which is as faithful as possible, the connection wires 5 and 7 below the component 1 are drawn substantially to scale (scale 50:1 mm).

In the region C, the connection wires are comparatively strongly deformed due to the fact that the flattened portions 9 and 11 are bent in the knees 13 and 15. This is due to the crosswise arrangement (not shown in the drawing) of the flattened portions 9 and 11. The connection wires 5 and 7 in certain electric components above the region B may also extend straight-through. In plate capacitors, the crosswise arrangement has the advantage that a high degree of stability is obtained with comparatively large plate surface areas. The deformation of the region C strongly depends upon the thickness of the component. In order to prevent the deformation from becoming excessively large, above a given thickness of the component use may be made of an oblique arrangement with respect to the connection wires. The central plane of a plate-shaped component then encloses an angle with the plane between the axes 4 and 6 of the connection wires.

The invention can be used in those electric components which are mounted with the aid of wire-shaped connections on a support and must have a defined distance from the support and/or a defined insertion depth of the connection wires. A component according to the invention has the advantage of a simple manufacturing process particularly suitable for soldering connections without the risk of the occurrence of gas occlusions.

**Claim**

An electric component having at least one connection made of metal wire to be mounted in a through-hole of a support with a printed circuit, this connection being provided with a shoulder adapted to bear on the support in a region located around the hole in the support and thus determining the insertion depth of the connection, characterized in that the shoulder (17) has the form of a disk having two oppositely arranged flattened portions (19, 21) which are parallel to each other and to the central axis (4, 6) of the connection (31, 33), the distance between the two flattened portions (19, 21) being smaller than the dimension of the shoulder (17) in a direction at right angles thereto, while the connection (5, 7) has a part (49) joining the shoulder (17) and having a substantially oval cross-section with a smallest surface area at the end remote from the shoulder (17) and a largest surface at the end facing the shoulder (17), the surface of the cross-section of this part (49) decreasing substantially linearly from the shoulder (17) and the plane through the major axis of the oval cross-section of this part (49) coinciding with the plane located equidistantly between the two flattened portions (19, 21) of the shoulder (17).

**Revendication**

Composant électrique muni d'au moins une connexion en fil métallique à monter dans une ouverture qui traverse un support portant un câblage imprimé, la connexion étant munie d'un épaulement qui prend appui contre le support dans une zone située près de l'ouverture dans le support et définit de la sorte la profondeur d'introduction de la connexion, caractérisé en ce que l'épaulement (17) est en forme de disque avec deux parties aplaties (19, 21) dont l'une se trouve diamétralement en face de l'autre, ces parties aplaties étant parallèles l'une à l'autre et à l'axe central (4, 6) de la connexion (31, 33), alors que la distance entre les deux parties aplaties (19, 21) est inférieure à la dimension de l'épaulement (17) dans une direction perpendiculaire à celui-ci, tandis que la connexion (5, 7) a une partie (49) qui se raccorde à l'épaulement (17) et présente une section transversale pratiquement ovale ayant sa surface la plus petite à l'extrémité située à l'opposé de l'épaulement (17) et sa surface la plus grande à l'extrémité située du côté de l'épaulement (17), la surface de la section transversale ovale de ladite partie (49) décroissant de façon pratiquement linéaire depuis l'épaulement (17) alors que le plan passant par le grand axe de la section transversale ovale de la partie (49) coïncide avec le plan équidistant entre les deux parties aplaties (19, 21) de l'épaulement (17).

**Patentanspruch**

Elektrisches Baueinheit mit zumindest einer Metalldrahtverbindung für die Montage in einem durch einen gedruckten Verdrahtungsträger hindurchgehenden Loch, wobei diese Verbindung mit einem Vorsprung versehen ist der sich am Träger in einem Bereich abstützt, der nahe bei Loch im Träger liegt und damit die Einstecktiefe der Verbindung bestimmt, dadurch gekennzeichnet, dass der Vorsprung (17) die Form einer Scheibe mit zwei einander gegenüberliegend angeordneten abgeflachten Teilen (19, 21) hat, die parallel zueinander und zur Zentralachse (4, 6) der Verbindung (31, 33) verlaufen, wobei der Abstand zwischen den zwei abgeflachten Teilen (19, 21) kleiner als die senkrecht dazu verlaufende Abmessung des Vorsprungs (17) ist, während die Verbindung (5, 7) einen sich an den Vorsprung (17) anschliessenden Teil (49) besitzt und eine im wesentliche ovalen Querschnitt mit einer kleinsten Oberfläche an dem dem Vorsprung (17) abgewandten Ende und eine grösste Oberfläche an dem dem Vorsprung (17) zugewandten Ende aufweist, wobei die Oberfläche des Querschnitts dieses Teiles (49) vom Vorsprung (17) im wesentlichen linear abnimmt, und die Ebene durch die Hauptachse des ovalen Querschnitts dieses Teiles (49) mit der Ebene zusammenfällt, die in gleichem Abstand zwischen den zwei abgeflachten Teilen (19, 21) des Vorsprungs (17) vorhanden ist.

FIG.1

FIG.3

FIG.2